(19) Europäisches Patentamt
European Patent Office
Office européen des brevets

(11) EP 2 782 256 B1

(12) **EUROPEAN PATENT SPECIFICATION**

(45) Date of publication and mention of the grant of the patent:
**13.06.2018 Bulletin 2018/24**

(51) Int Cl.:
***H03M 1/06*** *(2006.01)* *H03M 1/68* *(2006.01)*
*H03K 17/06* *(2006.01)*

(21) Application number: **13160547.9**

(22) Date of filing: **22.03.2013**

(54) **A digital to analogue converter**

Digital-Analog-Umsetzer

Convertisseur numérique-analogique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**24.09.2014 Bulletin 2014/39**

(73) Proprietor: **Rohm Co., Ltd.**
**Kyoto-shi, Kyoto 615-8585 (JP)**

(72) Inventor: **Mladenova, Irina**
**Ukyo-ku, Kyoto 615-8585 (JP)**

(74) Representative: **Isarpatent**
**Patent- und Rechtsanwälte Behnisch Barth Charles**
**Hassa Peckmann & Partner mbB**
**Friedrichstrasse 31**
**80801 München (DE)**

(56) References cited:
**US-A- 5 767 733** **US-A1- 2001 038 351**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 782 256 B1

## Description

The invention relates to a voltage scaling segmented string digital to analogue converter, DAC, with improved linearity.

US 2001/038351 A1 discloses a digitally switched impedance having improved linearity by minimizing the amount of impedance error introduced by switchers used to switch the impedance elements comprising digitally switched impedance. Improved settling time of the digitally switched impedance is achieved by reducing the amount of switch capacitance connected to the output of the digitally switched impedance.

US 5 767 733 A relates to a biasing circuit for reducing body effect in a bi-directional field effect transistor (FET). A FET includes a first source/drain terminal, a body terminal, and a second source/drain terminal. A bi-directional N-channel FET circuit includes a biasing circuit which couples the body terminal of the bi-directional FET to one of its first and second source/drain terminals.

One can differentiate between current scaled, voltage scaled or charge scaled digital to analogue converters. Voltage scaling digital to analogue converters are adapted to generate an analogue output voltage by selectively tapping a voltage dividing resistor string connected between a positive and negative reference voltage. For an n-bit voltage scaling digital to analogue converter, a resistor string can consist of $2^n$ identical resistors having the same resistance connected in series to each other. This resistor string can be used as a potentiometer in which the voltage levels between successive resistors are sampled by means of binary switches.

Fig. 1 shows a conventional n-bit digital to analogue converter, DAC, that operates on a voltage scaling principle as described in US 5,495,245. As can be seen in Fig. 1, a resistor string consisting of resistors is connected between a high reference voltage $V_{ref+}$ and a negative reference voltage $V_{ref-}$. The voltage output is sampled by a decoding switch network illustrated by switches $S_i$ wherein each switch taps a different point in the resistor string. Consequently, closing a particular switch by leaving the other switches open places a unique analogue voltage at the output of the resistor string. A decoder not shown in Fig. 1 controls the operation of the switches so that the switch $S_i$ whose output voltage corresponds to the magnitude of the input digital value is closed. The signal of the analogue output line can be sensed by a high impedance buffer amplifier as illustrated in Fig. 1.

A drawback of this conventional voltage scaling digital to analogue converter, DAC, is the very large number of components required, i.e. $2^n$ resistors and $2^n$ switches as well as $2^n$ logic drive lines for an n-bit voltage scaling digital to analogue converter, DAC.

Accordingly, voltage scaling digital to analogue converters have been proposed, wherein the number of required resistors and switches are reduced significantly by using a first resistor string for the most significant bits MSBs of the digital input signal and using a separate resistor string for the least significant bits LSBs of the applied input digital signal.

Fig. 2 shows a circuit diagram for illustrating an architecture of a voltage scaling segmented string digital to analogue converter, DAC, allowing a resolution of 6 (3+3) bits and comprising a most significant bit, MSB, resistor string for the most significant bits, MSBs, and a least significant bit, LSB, resistor string for the least significant bits, LSBs, of the digital input signal. As can be seen, the least significant bit, LSB, resistor string comprises $2^n$-1 (n=3) resistors for an input signal having n bits. Both ends of the least significant bit, LSB, resistor string are connected across one of the resistors within the MSB resistor string as illustrated in Fig. 2. By varying the MSB resistor selected for the LSB string connection and taking an output on the LSB resistor string, outputs in one LSB increments can be obtained over the full range of the LSBs. The conventional voltage scaling segmented string digital to analogue converter, DAC, shown in Fig. 2 is a 6-bit implementation. The conventional digital to analogue converter, DAC, as illustrated in Fig. 2 is intrinsically monotonic and at relatively high reference voltages $V_{ref}$ a linear performance of the digital to analogue converter, DAC, can be achieved. The resistance of the resistors within the two resistor strings can be equal, except that the top resistor of the MSB resistor string is smaller $1/2^K$ than the value of the other resistors, wherein the LSB resistor string has $2^K$-1 resistors rather than $2^K$ resistors. The LSB resistor string of the conventional digital to analogue converter, DAC, as illustrated in Fig. 2 is connected in parallel with the resistors of the MSB resistor string that it is switched across and loads it. This drops the voltage across the MSB resistor by 1 LSB of the LSB DAC as required. In a standard CMOS implementation of the digital to analogue converter, DAC, the switches used for commutating of the LSB resistor string can be implemented by transmission gates.

However, at low supply voltages, especially for the transmission gates placed in the middle of the resistor string the following problem occurs. The gate-source voltage $V_{GS}$ of the MOS transistor switches provided within the transmission gates is not sufficient to fully close the respective MOS transistor switch. Consequently, the switch on resistance $R_{ON}$ of the respective transistor switch becomes high. In the middle of a resistor string or chain, both NMOS and PMOS can comprise a high on resistance for the respective gate-source voltage $V_{GS}$ that is not sufficient, i.e. too low to close the respective MOS transistor switch and the transistor switch does consequently not conduct sufficiently.

Fig. 3 illustrates a typical switch on resistance performance of a transmission gate depending on an input voltage in a conventional digital to analogue converter, DAC. As can be seen, the resistance of a transmission gate can become especially in the middle range (for balanced transmission gates) very high as illustrated in Fig. 3. Because the resistance appears in serial connection with the LSB resistor string, this can affect drastically the linearity, INL, DNL, of the conventional digital to analogue converter, DAC. In some cases, the main reason for this negative effect is the backgate effect. The backgate effect is the increase of the MOS threshold voltage when the source-bulk potential is higher than zero what is the case when transmission gates are used.

Accordingly, it is an object of the present invention to provide a digital to analogue, DAC, converter providing a high linearity even at low supply voltages applied to the digital to analogue converter.

This object is achieved by a digital to analogue, DAC, converter comprising the features of claim 1.

In a possible embodiment of the digital to analogue converter according to the first aspect of the present invention, the MSB resistor string comprises a predetermined number of resistors being connected in series between a positive reference voltage and a negative reference voltage.

In a still further possible embodiment of the digital to analogue converter according to the first aspect of the present invention, the resistors of the MSB resistor string are connected to each other at junction nodes, wherein each junction node is switchable by a high transmission gate to a high end of the LSB resistor string and by a low transmission gate to a low end of the LSB resistor string.

In a still further possible embodiment of the digital to analogue converter according to the first aspect of the present invention, the digital to analogue converter further comprises a selection multiplexer adapted to generate in response to the digital input signal selection control bits each applied to a corresponding transmission gate of a resistor string to select a tap at the respective resistor string.

In a still further possible embodiment of the digital to analogue converter according to the first aspect of the present invention, each transmission gate comprises two complementary transmission gate MOSFETs each having a bulk terminal switchable to the source terminal or to the drain terminal of the respective transmission gate MOSFET in response to the thermometer encoded up/down control bit applied to said transmission gate by said thermometer coder in response to said digital input signal.

In a further possible embodiment of the digital to analogue converter according to the first aspect of the present invention, the two complementary transmission gate MOSFETs of the transmission gate comprise an isolated PMOS transistor and an isolated NMOS transistor.

In a further possible embodiment of the digital to analogue converter according to the first aspect of the present invention, the selection control bit is applied to the gate of a first MOSFET of the two complementary transmission gate MOSFETs and the inverted selection control bit is applied to the gate of the second complementary transmission gate MOSFET of the two complementary transmission gate MOSFETs within said transmission gate.

In a still further possible embodiment of the digital to analogue converter according to the first aspect of the present invention, for each of the two complementary transmission gate MOSFETs of the transmission gate two switching MOSFETs are provided adapted to switch the bulk terminal of the transmission gate MOSFET either to the source terminal or to the drain terminal of the respective transmission gate MOSFET in response to the encoded up/down control bit applied to said transmission gate by said thermometer coder in response to the digital input signal.

In a further possible embodiment of the digital to analogue converter according to the first aspect of the present invention, each transmission gate provided within an upper half of the MSB resistor string connected to the positive reference voltage comprises switching MOSFETs formed by PMOS transistors.

In a further possible embodiment of the digital to analogue converter according to the first aspect of the present invention, each transmission gate provided within a lower half of the MSB resistor string connected to the negative reference voltage comprises switching MOSFETs formed by NMOS transistors.

In a further possible embodiment of the digital to analogue converter according to the first aspect of the present invention, the digital analogue converter comprises a digital input connected to the thermometer coder and to the selection multiplexer of said digital analogue converter.

In a further possible embodiment of the digital to analogue converter according to the first aspect of the present invention, each analogue converter comprises an analogue output connected to the least significant bit, LSB, resistor string of said digital to analogue converter.

According to a further aspect of the present invention, a transmission gate for a resistor string of a digital analogue converter is provided, wherein the transmission gate comprises at least one transmission gate MOSFET having a bulk terminal switchable to the source terminal or to the drain terminal of the respective transmission gate MOSFET depending on a source-drain voltage polarity.

In a possible embodiment of the transmission gate according to the second aspect of the present invention, the transmission gate comprises two complementary transmission gate MOSFETs each having a bulk terminal switchable to the source terminal or to the drain terminal of the respective transmission gate MOSFET in response to a thermometer encoded up/down control bit applied to the transmission gate by a thermometer coder in response to a digital input signal.

In a further possible embodiment of the transmission gate according to the second aspect of the present invention, the two complementary transmission gate MOSFETs of the transmission gate comprise an isolated PMOS transistor and an isolated NMOS transistor.

In a further possible embodiment of the transmission gate according to the second aspect of the present invention, a selection control bit is applied to the gate of the first MOSFET of the two complementary transmission gate MOSFETs and an inverted selection control bit is applied to the gate of the second MOSFET of the two complementary transmission gate MOSFETs of said transmission gate.

In a further possible embodiment of the transmission gate according to the second aspect of the present invention, the control bit is applied by a selection multiplexer and generated by said selection multiplexer in response to the digital input signal.

In a further possible embodiment of the transmission gate according to the second aspect of the present invention, for each of the two complementary transmission gate MOSFETs of the transmission gate two switching MOSFETs are provided adapted to switch the bulk terminal of said transmission gate MOSFET either to the source terminal or to the drain terminal of the respective transmission gate MOSFET in response to the encoded up/down control bit applied to the transmission gate by said thermometer encoder in response to the digital input signal.

In the following, possible embodiments of the digital analogue converter according to the first aspect of the present invention and of a transmission gate according to a second aspect of the present invention are described in more detail with reference to the enclosed figures.

Fig. 1 shows a schematic diagram of a conventional voltage scaling digital analogue converter having a single resistor string;

Fig. 2 shows a schematic diagram illustrating a voltage scaling segmented string digital analogue converter comprising a most significant bit resistor string and a least significant bit resistor string;

Fig. 3 shows a diagram of a switch on resistance performance of a transmission gate depending on an input voltage in a conventional digital analogue converter illustrating a problem underlying the present invention;

Fig. 4 shows a possible implementation of a voltage scaling segmented string digital analogue converter with improved linearity according to the present invention;

Fig. 5A shows a circuit diagram of a possible implementation of a transmission gate according to the second aspect of the present invention as employed in the upper half of the MSB resistor string of the digital analogue converter as illustrated in Fig. 4;

Fig. 5B shows a further circuit diagram of a possible implementation of a transmission gate according to the second aspect of the present invention as employed within a lower half of an MSB resistor string within the digital analogue converter as illustrated in Fig. 4;

Fig. 6 shows a table of the signal states of an exemplary 6-bit digital analogue converter comprising a selection multiplexer and a thermometer coder.

As can seen in the implementation illustrated in Fig. 4, a digital to analogue converter, DAC, according to the present invention is adapted to convert a digital input signal into an analogue output voltage. The digital input signal comprising at least one digital word is applied to a digital input IN of the digital to analogue converter, DAC. In the implementation shown in Fig. 4, the digital input signal comprises a digital data word having 6 bits. The digital input IN of the digital to analogue converter, DAC, is connected to a selection multiplexer, MUX, and a thermometer encoding unit, TC, as illustrated in Fig. 4. The digital to analogue converter, DAC, comprises a most significant bit, MSB, resistor string and a least significant bit, LSB, resistor string, LSB-RS, as shown in Fig. 4. The most significant bit, MSB, resistor string is provided for the most significant bits of the digital input signal, whereas the least significant bit, LSB, resistor string is provided for the least significant bits of the digital input signal. In the shown implementation of Fig. 4, the 6 bits of the digital input signal are divided into three most significant bits, MSB, and into three least significant bits, LSB. Both resistor strings comprise serial connected resistors and transmission gates adapted to tap a voltage at the respective resistor string. The serial connected resistors can be formed by resistors and/or impedances having a complex resistance Z. As shown in Fig. 4, the MSB resistor string comprises a predetermined number of resistors or impedances $R_i$ with equal resistance (except the top one - its resistance is Ri/(number of resistances-1)) or impedance being connected in series to each other between a positive reference voltage $V_{ref+}$ and a negative voltage $V_{ref-}$. In the shown implementation, the negative reference voltage $V_{ref-}$ is formed by a ground potential GND. In the shown implementation of Fig. 4, the most significant bit, MSB, resistor string comprises nine resistors $R_{MSB1}$ to $R_{MSB9}$ connected in series to each other, wherein the resistors of the MSB resistor string are connected to each other at junction nodes as illustrated in Fig. 4. Each junction node is switchable by a high transmission gate, TGH, to a high end node, HN, and by a low transmission gate, TGL, to a low end node, LN, of the LSB resistor string. Accordingly, for each junction node of the MSB resistor string, a high transmission gate, TGH, and a low transmission gate, TGL, is provided. In the shown implementation of Fig. 4, a 6-bit digital input signal of the LSB resistor string comprises seven resistors $R_{LSB1}$ to $R_{LSB7}$ or impedances connected in series to each other between the high end node, HN, and the low end node, LN. The resistors or impedances of the LSB resistor string are also connected in series to each other at junction nodes. The resistors of the LSB resistor string can comprise the same or equal resistance or impedance. Each junction node of the LSB resistor string is also switchable by a transmission gate, TG, to an output terminal, OUT, of the digital to analogue converter, DAC, as illustrated in Fig. 4.

The thermometer coder, TC, of the digital to analogue converter, DAC, is adapted to generate in response to the digital input signal (Data) thermometer encoded up/down control bits. The thermometer coder, TC, can generate two up/down control bits for each pair of transmission gates, TG, consisting of a high transmission gate, TGH, and a low transmission gate, TGL, being connected to a junction node of the MSB resistor string. The up/down control bit u/d_1 is applied to the low transmission gate, TGL, and the up/down control bit u/d_h is applied to the high transmission gate, TGH, connected to the respective junction node within the MSB resistor string. Since in the shown implementation of Fig. 4 the MSB resistor string comprises nine resistances $R_{MSB1}$ to $R_{MSB9}$ connected in series to each other, the thermometer coder generates 2*9=18 up/down control bits applied to the pairs of high and low transmission gates, TGH, TGL, for the nine different junction nodes within the MSB resistor string.

The thermometer coder, TC, of the digital to analogue converter, DAC, as illustrated in Fig. 4, further generates up/down control bits $Lsb_u/d_i$ each applied to a corresponding transmission gate, TG, connected to a junction node within the LSB resistor string. In the shown implementation of Fig. 4 the thermometer coder, TC, generates eight up/down control bits for the eight junction nodes of the LSB resistor string provided between the high end node, HN, and the low end node, LN, as illustrated in Fig. 4. The up/down control bits generated by the thermometer coder, TC, for the 6-bit digital to analogue converter, DAC, applied to the different transmission gates, TG, of the MSB resistor string and the LSB resistor string are illustrated in the table of Fig. 6. Fig. 6 illustrates a table for a 6-bit digital to analogue converter, DAC, having 3 MSB and 3 LSB bits. Accordingly, there are $2^6$=64 different digital input words for which the thermometer coder, TC, generates corresponding up/down control bits applied to the corresponding transmission gates within the MSB resistor string and the LSB resistor string. With the digital to analogue converter, DAC, according to the present invention, the up/down control bits are provided to control a switching of a bulk terminal of at least one transmission gate MOSFET within the respective transmission gate, TG. In the digital to analogue converter, DAC, as illustrated in the implementation of Fig. 4, each transmission gate, TG, of the MSB resistor string comprises at least one transmission gate MOSFET having a bulk terminal B being switchable to the source terminal S or to the drain terminal D of the respective transmission gate MOSFET depending on a source-drain voltage polarity.

The digital to analogue converter, DAC, as illustrated in the implementation of Fig. 4 further comprises a selection multiplexer, MUX. This selection multiplexer, MUX, is adapted to generate in response to the digital input signal selection control bits, wherein each selection control bit is applied to a corresponding transmission gate, TG, of a resistor string to select a tap at the respective resistor string. In the shown implementation of Fig. 4, the selection multiplexer generates selection control bits for the transmission gates, TGH, TGL, of the most significant bit, MSB, resistor string and for the transmission gates, TG, of the least significant bit, LSB, resistor string. Accordingly, the selection multiplexer, MUX, generates in the shown embodiment for each pair consisting of a high transmission gate, TGH, and a low transmission gate, TGL, two control selection bits $CRTL_{iL}$ and $CRTL_{iH}$, wherein the selection control bit $CRTL_{iL}$ is applied to the low transmission gate, TGL, and the selection control bit $CRTL_{iH}$ is applied to the high transmission gate, TGH. Since the most significant bit, MSB, resistor string of the digital to analogue converter, DAC, comprises in the shown implementation of Fig. 4 2*9 transmission gates, TG, the selection multiplexer generates 2*9 selection control bits applied to the eighteen transmission gates, TG, connected to the nine junction nodes of the MSB resistor string.

The selection multiplexer, MUX, is further adapted to generate in response to the digital input signal selection control bits applied to the corresponding transmission gates, TG, of the least significant bit, LSB, resistor string. In the shown implementation of Fig. 4, the selection multiplexer, MUX, generates eight selection control bits $lsb_crtl_i$ for the eight transmission gates, TG, provided for the LSB resistor string of the digital to analogue converter, DAC. The selection bits are generated by the multiplexer, MUX, in response to a digital word applied to the digital input IN of the digital to analogue converter, DAC, as illustrated in the table of Fig. 6.

Each transmission gate, TG, shown in the implementation of the digital to analogue converter of Fig. 4 can comprise two complementary transmission gate MOSFETs each having a bulk terminal B being switchable to the source terminal S or to the drain terminal D of the respective transmission gate MOSFET, wherein the switching is performed in response to the thermometer encoded up/down control bit applied to the respective transmission gate, TG, by the thermometer coder, TC, being generated by the thermometer coder, TC, in response to the digital input signal applied to the digital to analogue converter, DAC.

In a possible embodiment, the two complementary transmission gate MOSFETs of each transmission gate can comprise an isolated PMOS transistor and an isolated NMOS transistor. Figs. 5A, 5B show possible embodiments of transmission gates, TG, as employed in the MSB resistor string of the digital to analogue converter, DAC, illustrated in Fig. 4. In a possible embodiment, two different kinds of transmission gates are used for the transmission gates of the MSB resistor string. In a possible implementation, the upper half of the MSB resistor string connected to the positive reference voltage $V_{ref+}$ comprises a first type of transmission gates as illustrated in Fig. 5A, whereas the transmission gate of the lower half of the MSB resistor string connected to the negative reference voltage $V_{ref+}$ comprises a second type of transmission gates as illustrated in Fig. 5B. The use of two different types of transmission gates reduces a block area and improves a dynamic performance of the digital to analogue converter, DAC.

Both types of transmission gates, TG, illustrated in the Figs. 5A, 5B comprise two complementary transmission gate MOSFETs P1, N1, as shown in Figs. 5A, 5B. The first transmission gate MOSFET P1 is formed by an isolated PMOS transistor having a gate terminal G, a source terminal S, a drain terminal D and a bulk terminal B. The second transmission gate MOSFET is provided by an isolated NMOS transistor also having a gate terminal G, a drain terminal D, a source terminal S as well as a bulk terminal B. The gate G of the isolated NMOS transistor N1 forming a transmission gate MOSFET of the transmission gate, TG, receives a selection control bit from the multiplexer, MUX, within the digital to analogue converter, DAC, as illustrated in Fig. 4. The other complementary transmission gate MOSFET P1 is an isolated PMOS transistor having a gate G receiving a negative selection bit formed by the inverted selection control bit applied to the gate of the complementary isolated NMOS transistor N1. The transmission gates, TG, as illustrated in Figs. 5A, 5B are provided for connecting two nodes IN1, IN2 with each other. The first node IN1 is connected in the shown embodiment with a junction node of the most significant bit, MSB, resistor string. The second node IN2 can be connected either to the high end node, HN, of the LSB resistor string or to the low end node, LN, of the LSB resistor string within the digital to analogue converter, DAC. In the lower half of the MSB resistor string, the high transmission gate, TGH, as well as the low transmission gate, TGL, can be both implemented by a transmission gate, TG, as illustrated in Fig. 5A. The selection control bit applied to the gate terminals of the transmission gate MOSFETs P1, N1 is applied by the selection multiplexer, MUX, of the digital to analogue converter, DAC. The transmission gate, TG, as illustrated in Figs. 5A, 5B further comprises a control input to receive an up/down control bit from the thermometer coder, TC, as illustrated in Fig. 4. Both complementary transmission gate MOSFETs P1, N1 have a bulk terminal B which is switchable either to the source terminal S or to the drain terminal D of the respective transmission gate MOSFET. This is done in response to the thermometer encoded up/down control bit applied to the transmission gate, TG, by the thermometer coder, TC. As can be seen in the embodiments of Figs. 5A, 5B, for each of the two complementary transmission gate MOSFETs P1, N1 two switching MOSFETs are provided to switch the bulk terminal B of the respective transmission gate MOSFET P1, N1 either to the source terminal S or to the drain terminal D of the respective transmission gate MOSFET. In the embodiment shown in Fig. 5A, a first switching MOSFET SWP1S is provided for switching the bulk terminal B of the transmission gate MOSFET P1 to the source terminal S of the transmission gate MOSFET P1. A further switching MOSFET SWP1D is adapted to switch the bulk terminal B of the transmission gate MOSFET P1 to the drain terminal D of the respective transmission gate MOSFET P1.

Two switching MOSFETs are also provided for the other transmission gate MOSFET N1. A first switching MOSFET SWN1S is adapted to switch the bulk terminal B of the transmission gate MOSFET N1 to the source terminal S of the transmission gate MOSFET N1. The second switching MOSFET SWN1D is adapted to switch the bulk terminal B of the transmission gate MOSFET N1 to the drain terminal D of the transmission gate MOSFET N1. As can be seen in Fig. 5A as well as in Fig. 5B, the gates of the switching MOSFETs are cross-connected to each other. In the implementation shown in Fig. 5A, the gate of the first switching transistor SWP1S of the isolated PMOS transmission gate MOSFET P1 is connected to the gate of the switching transistor SWN1S of the isolated NMOS transmission gate MOSFET N1 of the transmission gate, TG. In the same manner, the gate of the second switching transistor SWP1D of the first transmission gate MOSFET P1 is connected to the other switch SWN1D of the transmission gate MOSFET N1. Accordingly, either the pair of switching transistors SWP1S, SWN1S or the other pair of switching transistors SWP1D, SWN1D are switched through at the same time. Accordingly, the bulk B of the isolated PMOS transmission gate MOSFET P1 is either connected to its drain terminal D or to its source terminal S. The same applies to the other isolated NMOS transmission gate MOSFET N1. The switching of the switching MOSFETs SWP1S, SWP1D, SWN1S, SWN1D is controlled by the up/down control bit which in the implementation of Fig. 5A is applied to the gates of the switching transistors SWP1D, SWN1D via an inverter circuit, INV. The other gates of the other two switching transistors SWP1S, SWN1S receive an up/down control bit directly from the thermometer coder, TC. The transmission gate, TG, as illustrated in Fig. 5A comprises two complementary transmission gate MOSFETs P1, N1 and four additional switching MOSFETs which are adapted to connect the bulk B of the transmission gate MOSFETs P1, N1 either to the source S or drain terminals D depending on the source-drain voltage polarity. The bulk B of the isolated PMOS transmission gate MOSFET P1 is switched to the higher potential side, whereas the bulk B of the isolated NMOS transmission gate MOSFET N1 is switched to the lower potential side. In a possible embodiment, the up/down control bit applied to the control input of the transmission gate, TG, is logical low when the voltage at the first node IN1 is higher or equal than the voltage at the second node IN2. If $V_{IN1} \geq V_{IN2}$, the up/down control bit is logical low. In contrast, if the input voltage at the second node $V_{IN2}$ is lower than the voltage at the first input node $V_{IN1}$, the up/down control bit is logical high.

As can be seen in Fig. 5A, the transmission gate, TG, used for the upper half of the MSB resistor string comprises switching transistors formed by PMOS transistors. In contrast, the transmission gate, TG, shown in Fig. 5A and used for the lower half of the MSB resistor string comprises switching transistors formed by NMOS transistors. Accordingly, the switching transistors SWP1S, SWP1D, SWN1D, SWN1S are formed by NMOS transistors in the embodiment shown in Fig. 5A and by NMOS transistors in the embodiment shown in Fig. 5B. The switching transistors alternatively connect the bulk B of a transmission gate MOSFET to its source S or drain terminal D depending on the source-drain voltage polarity. Where the bulk terminal B of the transmission gate MOSFET is connected to depends on the addressed tap of the corresponding resistor string. If the switch is placed above the selected taps, the bulk of the PMOS switch is connected to the resistor string and the bulk of the NMOS switch is connected to a common node and vice versa. For controlling the up/down control bits which determines where the bulk B is connected to, the thermometer coder, TC, is used. The thermometer coder, TC, is controlled by the DAC input digital data and produces different outputs always when the data changes. The signals u/d_h and u/d_1 control the bulk connections B within the MSB resistor string, whereas the signals lsb_u/d control the bulk connection of the second LSB resistor string. The signals crtl_h and crtl_l are used to select the taps of the MSB resistor string. The signal lsb_crtl selects the tap of the LSB resistor string which is connected to the output of the digital to analogue converter, DAC.

The transmission gates, TG, control two complementary transmission gate MOSFETs P1, N1. The ON characteristics of such a MOS switch is given in a non-saturation region ($V_{DS} < V_{GS}-V_T$) as:

$$i_D = \frac{K'W}{L}\left[(v_{GS} - V_T) - \frac{v_{DS}}{2}\right]v_{DS} \quad (1)$$

so that:

$$\frac{\partial i_D}{\partial v_{DS}} = \frac{K'W}{L}\left[v_{GS} - V_T - v_{DS}\right] \quad (2)$$

Consequently, the switched on resistance $R_{ON}$ can be expressed as:

$$R_{ON} = \frac{\partial v_{DS}}{\partial i_D} = \frac{1}{\frac{K'W}{L}(v_{GS} - V_T - v_{DS})}, \quad (3)$$

wherein K is a factor,

W is the width and L is the length of a channel,
$V_{GS}$ is the gate-source voltage,
$V_T$ is the threshold voltage, and
$V_{DS}$ is the drain-source voltage applied to the respective MOS transistor.

The OFF characteristic of such a MOS switch is given as follows:
If $V_{GS} < V_T$, then $i_D = I_{OFF} = 0$ when $V_{DS} = 0V$.

If the drain-source voltage $V_{DS}$ is higher than 0, $V_{DS} > 0$, then the OFF resistance of the MOS switch is given by:

$$R_{OFF} \approx \frac{1}{i_{DS}\lambda} = \frac{1}{I_{OFF}\lambda} \approx \infty \quad (4)$$

As can be seen from equation (3), one needs a sufficient high gate-source voltage $V_{GS}$ to provide a sufficiently low ON resistance $R_{ON}$ of the respective MOS transmission gate MOSFET. If, for instance, a MOS switch connects two circuits and an analogue signal does vary in a range from 0 to 5V, the voltages required at the terminals of the MOS switch or transmission gate MOSFET must be chosen or adjusted properly. The bulk voltage must be less than or equal to zero to ensure that the bulk-source and bulk-drain are reverse biased. The gate voltage must be greater than 5V plus the threshold voltage $V_T$ in order to turn the MOS switch on. Consequently, $V_{BULK} \leq 0V$ and $V_G \geq 5V + V_T$. In the digital to analogue converter, DAC, according to the present invention by reducing the threshold voltage $V_T$ of the switching devices, i.e. the transmission gate MOSFETs, the backgate effect is cancelled and the $R_{ON}$ resistance is decreased, thus improving the linearity of the digital to analogue converter, DAC. By using two types of transmission gates, TG, for the upper and lower part of the MSB resistor string, a block area can be reduced and the dynamic performance of the digital to analogue converter, DAC, can be improved. Using switches with reduced switch on resistance $R_{ON}$ in both resistor strings reduces the output resistance of the digital to analogue converter, DAC, and increases its bandwidth.

As a further aspect of the present invention, a transmission gate, TG, is provided which comprises at least one transmission gate MOSFET having a bulk terminal B switchable to the source terminal S or to the drain terminal D of the respective transmission gate MOSFET depending on a source-drain voltage polarity. This transmission gate, TG, can be used for resistor strings within a digital to analogue converter, DAC, according to the first aspect of the present invention. This kind of transmission gate can be used in other circuits as well.

The digital to analogue, DAC, converter as illustrated for instance in the embodiment shown in Fig. 4 can be used especially for reduced supply voltages with low reference voltages $V_{ref+}$, $V_{ref-}$. For instance, the digital to analogue converter as illustrated in Fig. 4 may be used when the difference between the positive reference voltage $V_{ref+}$ and the negative reference voltage $V_{ref-}$ is lower than 5V. The voltage between the source S and drain terminal D can change polarity depending on which resistor divider tap the input of the respective transmission gate, TG, is connected to and the voltage at the output. There are two groups of transmission gates, TG, wherein the output terminal of the first group of transmission gates is connected to the positive high end of the MSB resistor string, wherein the output terminal of the other group of transmission gates is connected to the low end node, LN, of the LSB resistor string. Because different voltages can be switched to the above-mentioned nodes, their potential can vary between the lowest and highest possible value. That means, for small digital codes the group node is low, whereas for big digital codes the potential can be high. The digital to analogue converter, DAC, with improved linearity according to the present invention uses isolated transmission gate MOSFETs with additional switches which can be controlled to alternatively connect the bulk terminal B of the transmission gate MOSFET either to the source S or drain terminals D depending on the source-drain voltage polarity.

## Claims

**1.** A digital to analogue, DAC, converter adapted to convert a digital input value into an analogue output voltage said digital to analogue, DAC, converter comprising:

a most significant bit, MSB, resistor string provided for the most significant bits, MSB, of the digital input value, and a least significant bit, LSB, resistor string for the least significant bits, LSB, of the digital input value,
wherein both resistor strings comprise serial connected resistors and transmission gates adapted to tap a voltage from the respective resistor string,
**characterized in that**
each transmission gate of the MSB resistor string comprises at least one transmission gate MOSFET having a bulk terminal (B) switchable to the source terminal (S) or to the drain terminal (D) of the respective transmission gate MOSFET depending on a source-drain voltage polarity,
wherein the digital to analogue, DAC, converter further comprising a thermometer coder (TC) adapted to generate in response to the digital input value thermometer encoded up/down control bits each applied to a corresponding transmission gate (TG) of a resistor string to control switching of a bulk terminal (B) of at least one transmission gate MOSFET within the respective transmission gate (TG).

**2.** The digital to analogue, DAC, converter according to claim 1, wherein the MSB resistor string comprises a predetermined number of resistors being connected in series between a positive reference voltage ($V_{ref+}$) and a negative reference voltage ($V_{ref-}$).

**3.** The digital to analogue, DAC, converter according to claim 1 and 2, wherein the resistors of the MSB resistor string are connected to each other at junction nodes,
wherein each junction node is switchable by a high transmission gate to a high end of the LSB resistor string and by a low transmission gate to a low end of the LSB resistor string.

**4.** The digital to analogue, DAC, converter according to one of the preceding claims 1 to 3, further comprising a selection multiplexer (MUX) adapted to generate in response to the digital input value selection control bits each applied to a corresponding transmission gate (TG) of a resistor string to select a tap at the respective resistor string.

**5.** The digital to analogue, DAC, converter according to one of the preceding claims 1 to 4, wherein each transmission gate (TG) comprises two complementary transmission gate MOSFETs each having a bulk terminal (B) switchable to the source terminal (S) or to the drain terminal (D) of the respective transmission gate MOSFET in response to the thermometer encoded up/down control bit applied to said transmission gate (TG) by said thermometer coder (TC) in response to said digital input value.

**6.** The digital to analogue, DAC, converter according to claim 5, wherein the two complementary transmission gate MOSFETs of said transmission gate (TG) comprise an isolated PMOS transistor and an isolated NMOS transistor, wherein the selection control bit is applied to the gate of the first MOSFET of the two complementary transmission gate MOSFETs and the inverted selection control bit is applied to the gate of the second complementary MOSFET of the two complementary transmission gate MOSFETs of the respective transmission gate (TG).

**7.** The digital to analogue, DAC, converter according to one of the preceding claims 5 or 6,
wherein for each of the two complementary transmission gate MOSFETs of the transmission gate (TG) two switching MOSFETs are provided adapted to switch the bulk terminal (B) of said transmission gate MOSFET either to the source terminal (S) or to the drain terminal (D) of the respective transmission gate MOSFET in response to the encoded up/down control bit applied to said transmission gate (TG) by said thermometer coder (TC) in response to said digital input value.

**8.** The digital to analogue, DAC, converter according to one of the preceding claims 1 to 7, wherein each transmission gate (TG) provided within an upper half of the MSB resistor string connected to the positive reference voltage ($V_{ref+}$) comprises switching MOSFETs formed by PMOS transistors.

**9.** The digital to analogue, DAC, converter according to one of the preceding claims 1 to 8, wherein each transmission gate (TG) provided within a lower half of the MSB resistor string connected to the negative reference voltage ($V_{ref-}$) comprises switching MOSFETs formed by NMOS transistors.

**10.** The digital to analogue, DAC, converter according to claim 4, wherein the digital to analogue converter, DAC, comprises a digital input to which the digital input value is applied, wherein the digital input is connected to the thermometer coder (TC) and to the selection multiplexer (MUX) of the digital to analogue converter, DAC.

**11.** The digital to analogue, DAC, converter according to one of the preceding claims 1 to 10, wherein the digital to analogue converter, DAC, comprises an analogue output for the output voltage connected to the least significant bit, LSB, resistor string of said digital to analogue converter, DAC.

## Patentansprüche

**1.** Digital-Analog-Wandler, DAC, der ausgelegt ist, um einen digitalen Eingangswert in eine analoge Ausgangspannung umzuwandeln,
wobei der Digital-Analog-Wandler, DAC, Folgendes umfasst:

eine Widerstandskette für höchstwertige Bits, MSB, die für die höchstwertigen Bits, MSB, des digitalen Eingangswerts bereitgestellt ist, und
eine Widerstandskette für niedrigstwertige Bits, LSB, für die niedrigstwerigen Bits, LSB, des digitalen Eingangswerts, wobei beide Widerstandsketten in Reihe geschaltete Widerstände und Übertragungsgatter umfassen, die ausgelegt sind, um eine Spannung von der jeweiligen Widerstandskette abzugreifen,
**dadurch gekennzeichnet, dass**
jedes Übertragungsgatter der MSB-Widerstandskette mindestens einen Übertragungsgatter-MOSFET mit einem Bulk-Anschluss (B) umfasst, der zu dem Source-Anschluss (S) oder zu dem Drain-Anschluss (D) des jeweiligen Übertragungsgatter-MOSFET in Abhängigkeit von einer Source-Drain-Spannungspolarität umschaltbar ist,
wobei der Digital-Analog-Wandler, DAC, ferner einen Thermometerkodierer (TC) umfasst, der ausgelegt ist, um als Reaktion auf den digitalen Eingangswert Thermometer kodierte Auf/Ab-Steuerbits zu erzeugen, die jeweils an ein entsprechendes Übertragungsgatter (TG) einer Widerstandskette angelegt sind, um ein Umschalten eines Bulk-Anschlusses (B) mindestens eines Übertragungsgatter-MOSFET innerhalb des jeweiligen Übertragungsgatters (TG) zu steuern.

**2.** Digital-Analog-Wandler, DAC, nach Anspruch 1, wobei die MSB-Widerstandskette eine vorbestimmte Anzahl von Widerständen umfasst, die in Reihe zwischen einer positiven Referenzspannung ($V_{ref+}$) und einer negativen Referenzspannung ($V_{ref-}$) geschaltet sind.

**3.** Digital-Analog-Wandler, DAC, nach Anspruch 1 und 2, wobei die Widerstände der MSB-Widerstandskette an Verzweigungsknoten aneinander geschaltet sind,
wobei jeder Verzweigungsknoten durch ein Hochübertragungsgatter zu einem hohen Ende der LSB-Widerstandskette und durch ein Niederübertragungsgatter zu einem niedrigen Ende der LSB-Widerstandskette umschaltbar ist.

**4.** Digital-Analog-Wandler, DAC, nach einem der vorhergehenden Ansprüche 1 bis 3, der ferner einen Auswahl-Multiplexer (MUX) umfasst, der ausgelegt ist, um als Reaktion auf den digitalen Eingangswert Auswahl-Steuerbits zu erzeugen, die jeweils an ein entsprechendes Übertragungsgatter (TG) einer Widerstandskette angelegt sind, um einen Abgriff an der jeweiligen Widerstandskette auszuwählen.

**5.** Digital-Analog-Wandler, DAC, nach einem der vorhergehenden Ansprüche 1 bis 4, wobei jedes Übertragungsgatter (TG) zwei komplementäre Übertragungsgatter-MOSFETs mit einem Bulk-Anschluss (B) umfasst, der zu dem Source-Anschluss (S) oder zu dem Drain-Anschluss (D) des jeweiligen Übertragungsgatter-MOSFET als Reaktion auf das Thermometer kodierte Auf/Ab-Steuerbit umschaltbar ist, das an das Übertragungsgatter (TG) durch den Thermometerkodierer (TC) als Reaktion auf den digitalen Eingangswert angelegt ist.

**6.** Digital-Analog-Wandler, DAC, nach Anspruch 5, wobei die zwei komplementären Übertragungsgatter-MOSFETs des Übertragungsgatters (TG) einen isolierten PMOS-Transistor und einen isolierten NMOS-Transistor umfassen, wobei das Auswahl-Steuerbit an das Gatter des ersten MOSFET der zwei komplementären Übertragungsgatter-MOSFETs angelegt ist und das invertierte Auswahl-Steuerbit an das Gatter des zweiten komplementären MOSFET der zwei komplementären Übertragungsgatter-MOSFETs des jeweiligen Übertragungsgatters (TG) angelegt ist.

**7.** Digital-Analog-Wandler, DAC, nach einem der vorhergehenden Ansprüche 5 oder 6,
wobei jedes der zwei komplementären Übertragungsgatter-MOSFETs der zwei Schalt-MOSFETs des Übertragungsgatters (TG) bereitgestellt sind, die ausgelegt sind, um den Bulk-Anschluss (B) des Übertragungsgatter-MOSFET entweder zu dem Source-Anschluss (S) oder zu dem Drain-Anschluss (D) des jeweiligen Übertragungsgatter-MOSFET als Reaktion auf das kodierte Auf/Ab-Steuerbit umzuschalten, das an das Übertragungsgatter (TG) durch den Thermometerkodierer (TC) als Reaktion auf den digitalen Eingangswert angelegt ist.

**8.** Digital-Analog-Wandler, DAC, nach einem der vorhergehenden Ansprüche 1 bis 7, wobei das Übertragungsgatter (TG), das innerhalb einer oberen Hälfte der MSB-Widerstandskette bereitgestellt ist, die an die positive Referenzspannung ($V_{ref+}$) geschaltet ist, Schalt-MOSFETs umfasst, die durch PMOS-Transistoren gebildet sind.

**9.** Digital-Analog-Wandler, DAC, nach einem der vorhergehenden Ansprüche 1 bis 8, wobei jedes Übertragungsgatter (TG), das innerhalb einer unteren Hälfte der MSB-Widerstandskette bereitgestellt ist, die an die negative Referenzspannung ($V_{ref-}$) geschaltet ist, Schalt-MOSFETs umfasst, die durch NMOS-Transistoren gebildet sind.

**10.** Digital-Analog-Wandler, DAC, nach Anspruch 4, wobei der Digital-Analog-Wandler, DAC, einen digitalen Eingang umfasst, an den der digitale Eingangswert angelegt ist, wobei der digitale Eingang an den Thermometerkodierer (TC) und an den Auswahl-Multiplexer (MUX) des Digital-Analog-Wandlers, DAC, geschaltet ist.

**11.** Digital-Analog-Wandler, DAC, nach einem der vorhergehenden Ansprüche 1 bis 10, wobei der Digital-Analog-Wandler, DAC, einen analogen Ausgang für die Ausgangspannung umfasst, der an die Widerstandskette für niedrigstwertiges Bits, LSB, des Digital-Analog-Wandlers, DAC, geschaltet ist.

## Revendications

**1.** Convertisseur numérique-analogique, DAC, conçu pour convertir une valeur d'entrée numérique en une tension de sortie analogique, ledit convertisseur numérique-analogique, DAC, comprenant :

une chaîne de résistances de bits les plus significatifs, MSB, prévue pour les bits les plus significatifs, MSB, de la valeur d'entrée numérique, et
une chaîne de résistances de bits les moins significatifs, LSB, pour les bits les moins significatifs, LSB, de la valeur d'entrée numérique,
dans lequel les deux chaînes de résistances comprennent des résistances connectées en série et des grilles de transmission conçues pour prélever une tension de la chaîne de résistances respective,
**caractérisé en ce que**
chaque grille de transmission de la chaîne de résistances MSB comprend au moins un MOSFET de grille de transmission ayant une borne non épitaxiée (B) commutable à la borne de source (S) ou à la borne de drain (D) du MOSFET de grille de transmission respectif en fonction d'une polarité de tension source-drain,
dans lequel le convertisseur numérique-analogique, DAC, comprend en outre un codeur de thermomètre (TC) conçu pour générer, en réponse à la valeur d'entrée numérique, des bits de commande haut/bas codés de thermomètre appliqués chacun à une grille de transmission correspondante (TG) d'une chaîne de résistances pour commander la commutation d'une borne non épitaxiée (B) d'au moins un MOSFET de grille de transmission dans la grille de transmission (TG) respective.

**2.** Convertisseur numérique-analogique, DAC, selon la revendication 1, dans lequel la chaîne de résistances MSB comprend un nombre prédéterminé de résistances connectées en série entre une tension de référence positive ($V_{ref+}$) et une tension de référence négative ($V_{ref-}$).

**3.** Convertisseur numérique-analogique, DAC, selon les revendications 1 et 2, dans lequel les résistances de la chaîne de résistances MSB sont connectées les unes aux autres au niveau de noeuds de jonction,
dans lequel chaque noeud de jonction est commutable par une grille de transmission haute à une extrémité haute de la chaîne de résistances LSB et par une grille de transmission basse à une extrémité basse de la chaîne de résistances LSB.

**4.** Convertisseur numérique-analogique, DAC, selon l'une des revendications précédentes 1 à 3, comprenant en outre un multiplexeur de sélection (MUX) conçu pour générer, en réponse à la valeur d'entrée numérique, des bits de commande de sélection appliqués chacun à une grille de transmission (TG) correspondante d'une chaîne de résistances pour sélectionner une prise au niveau de la chaîne de résistances respective.

**5.** Convertisseur numérique-analogique, DAC, selon l'une des revendications précédentes 1 à 4, dans lequel chaque grille de transmission (TG) comprend deux MOSFET de grille de transmission complémentaires ayant chacun une borne non épitaxiée (B) commutable à la borne de source (S) ou à la borne de drain (D) du MOSFET de grille de transmission respectif en réponse au bit de commande haut/bas codé de thermomètre appliqué à ladite grille de transmission (TG) par ledit codeur de thermomètre (TC) en réponse à ladite valeur d'entrée numérique.

**6.** Convertisseur numérique-analogique, DAC, selon la revendication 5, dans lequel les deux MOSFET de grille de transmission complémentaires de ladite grille de transmission (TG) comprennent un transistor PMOS isolé et un transistor MOS isolé,
dans lequel le bit de commande de sélection est appliqué à la grille du premier MOSFET des deux MOSFET de grille de transmission complémentaires et le bit de commande de sélection inversé est appliqué à la grille du second MOSFET complémentaire des deux MOSFET de grille de transmission complémentaires de la grille de transmission (TG) respective.

**7.** Convertisseur numérique-analogique, DAC, selon l'une des revendications précédentes 5 ou 6,
dans lequel pour chacun des deux MOSFET de grille de transmission complémentaires de la grille de transmission (TG) deux MOSFET de commutation sont prévus, conçus pour commuter la borne non épitaxiée (B) dudit MOSFET de grille de transmission soit la borne de source (S), soit à la borne de drain (D) du MOSFET de grille de transmission respectif en réponse au bit de commande haut/bas codé appliqué à ladite grille de transmission (TG) par ledit codeur de thermomètre (TC) en réponse à ladite valeur d'entrée numérique.

**8.** Convertisseur numérique-analogique, DAC, selon l'une des revendications précédentes 1 à 7, dans lequel chaque grille de transmission (TG) prévue dans une moitié supérieure de la chaîne de résistances MSB connectée à la tension de référence positive ($V_{ref+}$) comprend des MOSFET de commutation formés par des transistors PMOS.

**9.** Convertisseur numérique-analogique DW selon l'une des revendications précédentes 1 à 8, dans lequel chaque grille de transmission (TG) prévue dans une moitié inférieure de la chaîne de résistances MSB connectée à la tension de référence négative ($V_{ref-}$) comprend des MOSFET de commutation formés par des transistors NMOS.

**10.** Convertisseur numérique-analogique, DAC, selon la revendication 4, dans lequel le convertisseur numérique-analogique, DAC, comprend une entrée numérique à laquelle la valeur d'entrée numérique est appliquée, dans lequel l'entrée numérique est connectée au codeur de thermomètre (TC) et au multiplexeur de sélection (MUX) du convertisseur numérique-analogique, DAC.

**11.** Convertisseur numérique-analogique, DAC, selon l'une des revendications précédentes 1 à 10, dans lequel le convertisseur numérique-analogique, DAC, comprend une sortie analogique pour la tension de sortie connectée à la chaîne de résistances de bits les moins significatifs, LSB, dudit convertisseur numérique-analogique, DAC.

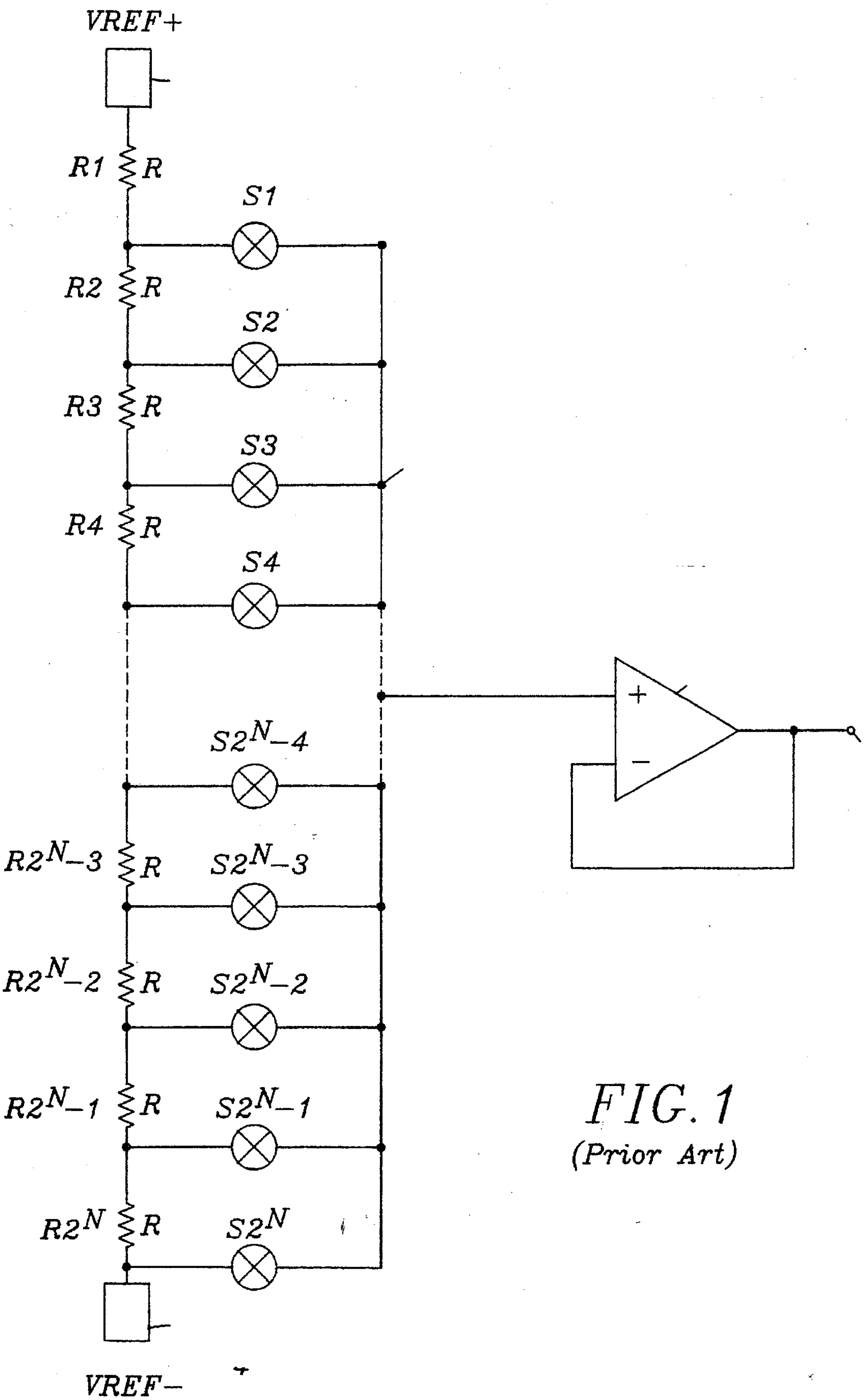


FIG. 1
(Prior Art)

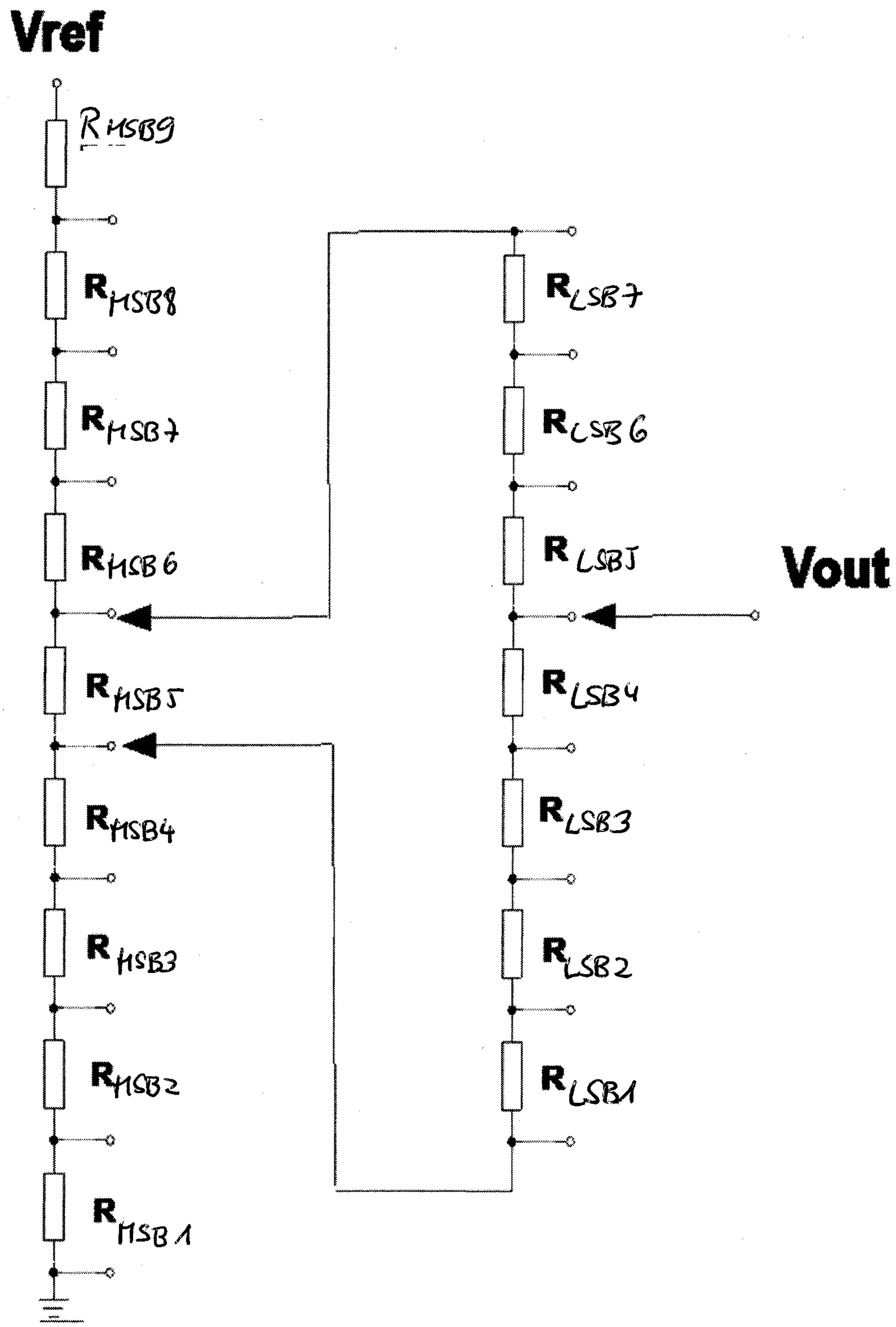


Fig 2 prior art

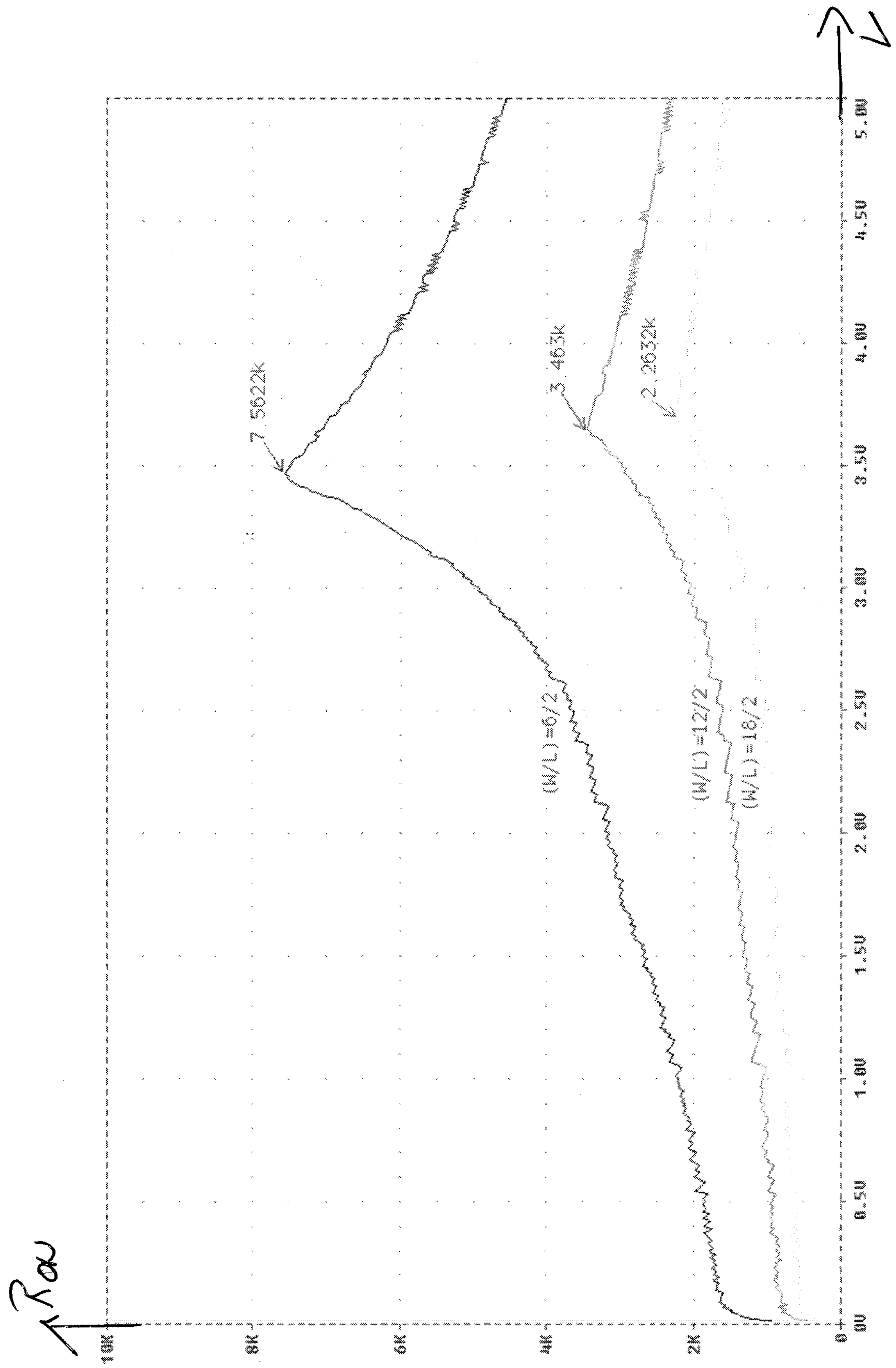
V
10K
8K
6K
4K
2K
0
0U
0.5U
1.0U
1.5U
2.0U
2.5U
3.0U
3.5U
4.0U
4.5U
5.0U
7.5622k
3.463k
2.2632k
(W/L)=6/2
(W/L)=12/2
(W/L)=18/2

Fig3

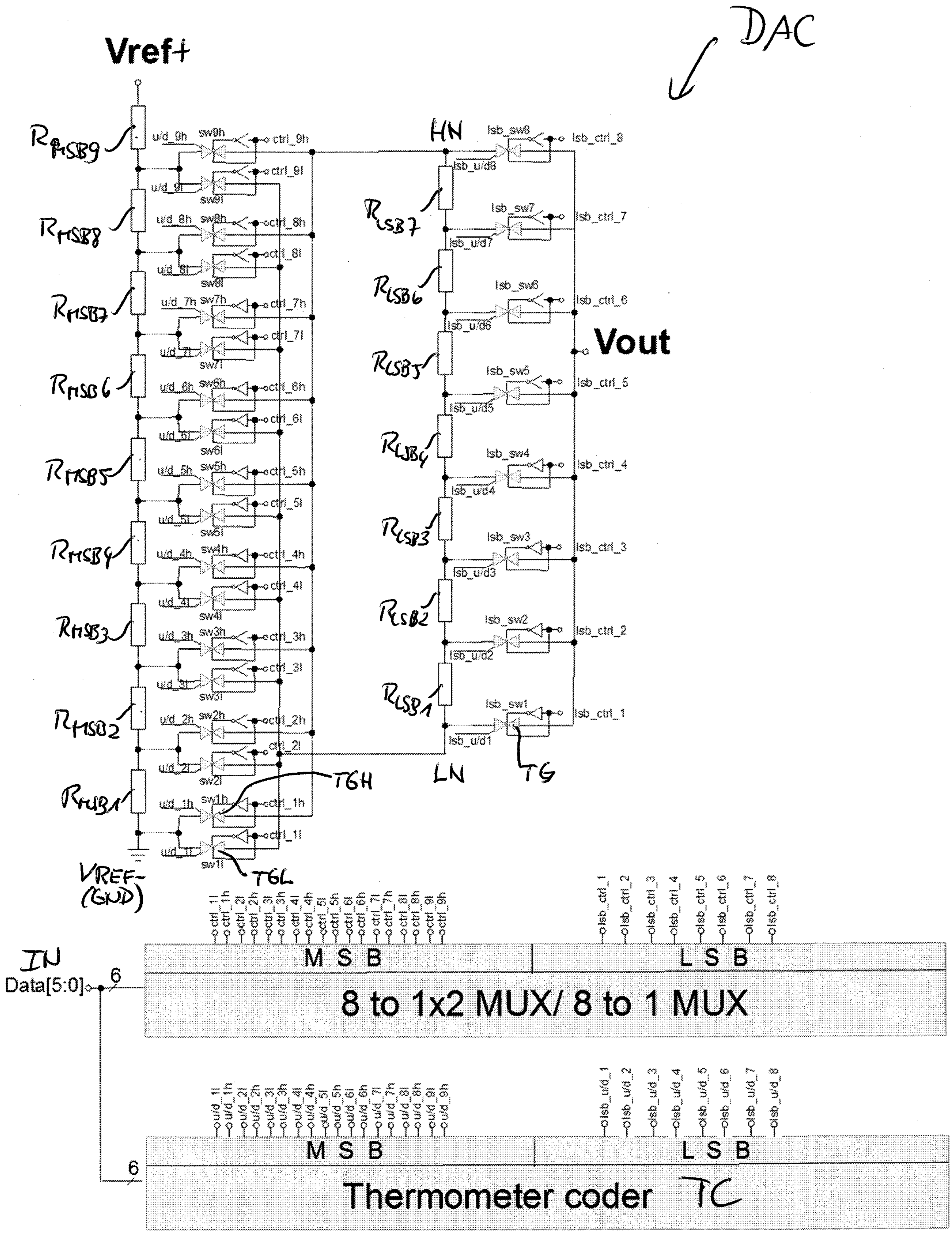
DAC
Vref+
Vout
HN
LN
TG
TGH
TGL
VREF-
(GND)
IN
Data[5:0]
6
M S B
L S B
8 to 1x2 MUX/ 8 to 1 MUX
Thermometer coder
TC

Fig 4

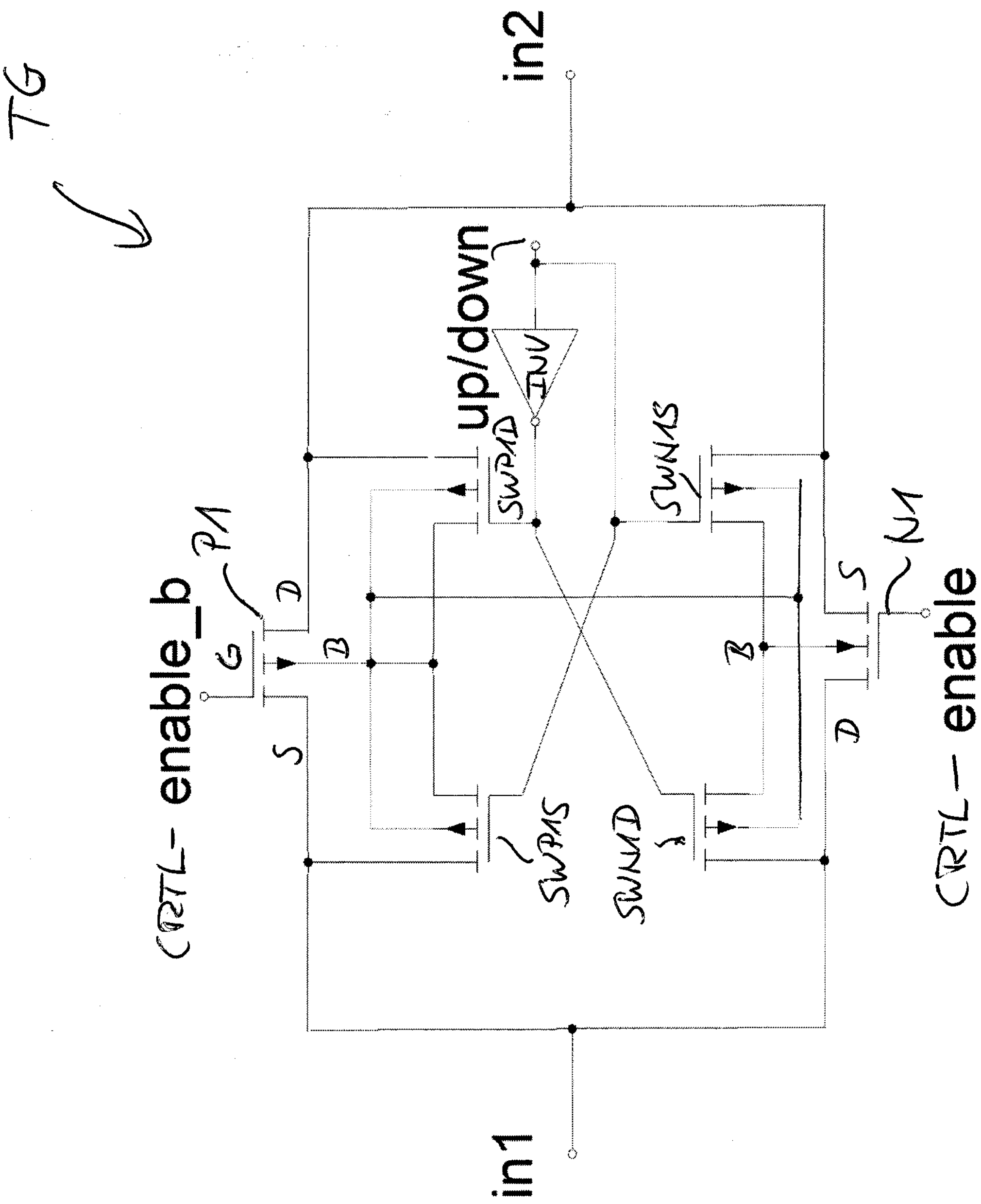
TG
in2
up/down
INV
CRTL- enable_b
P1
G
D
S
B
SWP1D
SWN1S
SWP1S
SWN1D
N1
CRTL- enable
in1

Fig 5A

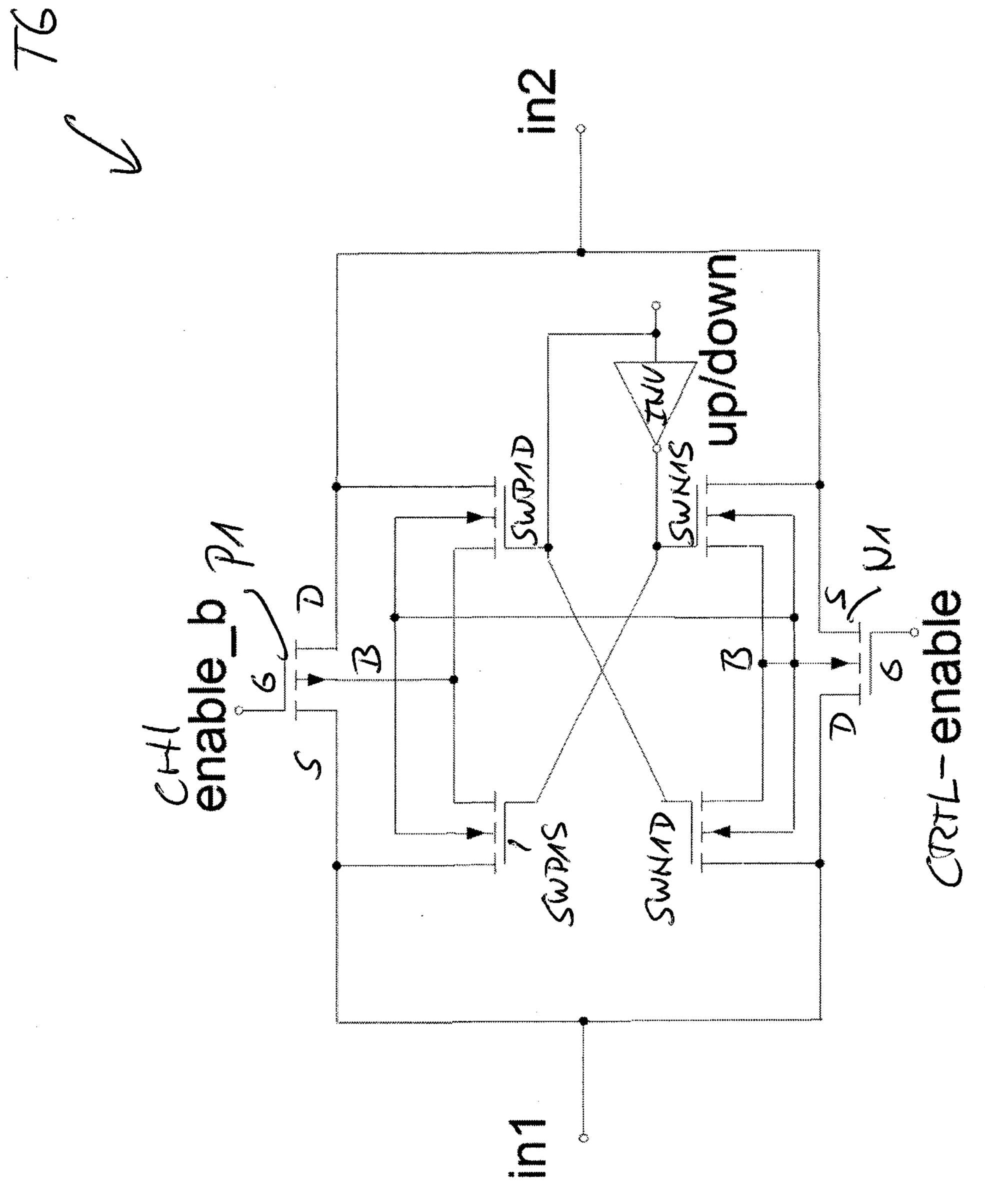
TG
in2
in1
up/down
INV
enable_b
CTRL-enable
P1
N1
SWP1D
SWP1S
SWN1S
SWN1D
G
S
D
B

Fig 5B

| Input | | 8 to 1x2 MUX | | | | | | | | | | | | | | | | | | 8 to 1 MUX | | | | | | | | Thermometer coder TC | | | | | | | | | | | | | | | | | | | | | | | | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| State | Digital word | ctrl_1l | ctrl_2l | ctrl_3l | ctrl_4l | ctrl_5l | ctrl_6l | ctrl_7l | ctrl_8l | ctrl_9l | ctrl_1h | ctrl_2h | ctrl_3h | ctrl_4h | ctrl_5h | ctrl_6h | ctrl_7h | ctrl_8h | ctrl_9h | lsb_ctrl_1 | lsb_ctrl_2 | lsb_ctrl_3 | lsb_ctrl_4 | lsb_ctrl_5 | lsb_ctrl_6 | lsb_ctrl_7 | lsb_ctrl_8 | up/down_1l | up/down_2l | up/down_3l | up/down_4l | up/down_5l | up/down_6l | up/down_7l | up/down_8l | up/down_9l | up/down_1h | up/down_2h | up/down_3h | up/down_4h | up/down_5h | up/down_6h | up/down_7h | up/down_8h | up/down_9h | lsb_up/down_1 | lsb_up/down_2 | lsb_up/down_3 | lsb_up/down_4 | lsb_up/down_5 | lsb_up/down_6 | lsb_up/down_7 | lsb_up/down_8 |
| 0 | 000000 | 1 | 0 | 0 | 0 | 0 | 0 | 0 | 0 | 0 | 0 | 1 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 |
| 1 | 000001 | 1 | 0 | 0 | 0 | 0 | 0 | 0 | 0 | 0 | 0 | 1 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 |
| 2 | 000010 | 1 | 0 | 0 | 0 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 |
| 3 | 000011 | 1 | 0 | 0 | 0 | 0 | 0 | 0 | 0 | 0 | 0 | 1 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 |
| 4 | 000100 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 |
| 5 | 000101 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 |
| 6 | 000110 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 |
| 7 | 000111 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 |
| 8 | 001000 | 0 | 1 | 0 | 0 | 0 | 0 | 0 | 0 | 0 | 0 | 0 | 1 | 0 | 0 | 0 | 0 | 0 | 0 | 1 | 0 | 0 | 0 | 0 | 0 | 0 | 0 | 1 | 0 | 0 | 0 | 0 | 0 | 0 | 0 | 0 | 1 | 1 | 0 | 0 | 0 | 0 | 0 | 0 | 0 | 1 | 0 | 0 | 0 | 0 | 0 | 0 | 0 |
| 9 | 001001 | 0 | 1 | 0 | 0 | 0 | 0 | 0 | 0 | 0 | 0 | 0 | 1 | 0 | 0 | 0 | 0 | 0 | 0 | 0 | 1 | 0 | 0 | 0 | 0 | 0 | 0 | 1 | 0 | 0 | 0 | 0 | 0 | 0 | 0 | 0 | 1 | 1 | 0 | 0 | 0 | 0 | 0 | 0 | 0 | 1 | 0 | 0 | 0 | 0 | 0 | 0 | 0 |
| 10 | 001010 | 0 | 1 | 0 | 0 | 0 | 0 | 0 | 0 | 0 | 0 | 0 | 1 | 0 | 0 | 0 | 0 | 0 | 0 | 0 | 0 | 1 | 0 | 0 | 0 | 0 | 0 | 1 | 0 | 0 | 0 | 0 | 0 | 0 | 0 | 0 | 1 | 1 | 0 | 0 | 0 | 0 | 0 | 0 | 0 | 1 | 0 | 0 | 0 | 0 | 0 | 0 | 0 |
| 11 | 001011 | 0 | 1 | 0 | 0 | 0 | 0 | 0 | 0 | 0 | 0 | 0 | 1 | 0 | 0 | 0 | 0 | 0 | 0 | 0 | 0 | 0 | 1 | 0 | 0 | 0 | 0 | 1 | 0 | 0 | 0 | 0 | 0 | 0 | 0 | 0 | 1 | 1 | 0 | 0 | 0 | 0 | 0 | 0 | 0 | 1 | 0 | 0 | 0 | 0 | 0 | 0 | 0 |
| 12 | 001100 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 1 | 0 | 0 | 0 | 1 | 0 | 0 | 0 | 0 | 0 | 0 | 0 | 0 | 1 | 1 | 0 | 0 | 0 | 0 | 0 | 0 | 0 | 1 | 0 | 0 | 0 | 0 | 0 | 0 | 0 |
| 13 | 001101 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 1 | 0 | 0 | 1 | 0 | 0 | 0 | 0 | 0 | 0 | 0 | 0 | 1 | 1 | 0 | 0 | 0 | 0 | 0 | 0 | 0 | 1 | 0 | 0 | 0 | 0 | 0 | 0 | 0 |
| 14 | 001110 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 1 | 0 | 1 | 0 | 0 | 0 | 0 | 0 | 0 | 0 | 0 | 1 | 1 | 0 | 0 | 0 | 0 | 0 | 0 | 0 | 1 | 0 | 0 | 0 | 0 | 0 | 0 | 0 |
| 15 | 001111 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 1 | 1 | 0 | 0 | 0 | 0 | 0 | 0 | 0 | 0 | 1 | 1 | 0 | 0 | 0 | 0 | 0 | 0 | 0 | 1 | 0 | 0 | 0 | 0 | 0 | 0 | 0 |
| 16 | 010000 | 0 | 0 | 1 | 0 | 0 | 0 | 0 | 0 | 0 | 0 | 0 | 0 | 1 | 0 | 0 | 0 | 0 | 0 | 1 | 0 | 0 | 0 | 0 | 0 | 0 | 0 | 1 | 1 | 0 | 0 | 0 | 0 | 0 | 0 | 0 | 1 | 1 | 1 | 0 | 0 | 0 | 0 | 0 | 0 | 1 | 1 | 0 | 0 | 0 | 0 | 0 | 0 |
| 17 | 010001 | 0 | 0 | 1 | 0 | 0 | 0 | 0 | 0 | 0 | 0 | 0 | 0 | 1 | 0 | 0 | 0 | 0 | 0 | 0 | 1 | 0 | 0 | 0 | 0 | 0 | 0 | 1 | 1 | 0 | 0 | 0 | 0 | 0 | 0 | 0 | 1 | 1 | 1 | 0 | 0 | 0 | 0 | 0 | 0 | 1 | 1 | 0 | 0 | 0 | 0 | 0 | 0 |
| 18 | 010010 | 0 | 0 | 1 | 0 | 0 | 0 | 0 | 0 | 0 | 0 | 0 | 0 | 1 | 0 | 0 | 0 | 0 | 0 | 0 | 0 | 1 | 0 | 0 | 0 | 0 | 0 | 1 | 1 | 0 | 0 | 0 | 0 | 0 | 0 | 0 | 1 | 1 | 1 | 0 | 0 | 0 | 0 | 0 | 0 | 1 | 1 | 0 | 0 | 0 | 0 | 0 | 0 |
| 19 | 010011 | 0 | 0 | 1 | 0 | 0 | 0 | 0 | 0 | 0 | 0 | 0 | 0 | 1 | 0 | 0 | 0 | 0 | 0 | 0 | 0 | 0 | 1 | 0 | 0 | 0 | 0 | 1 | 1 | 0 | 0 | 0 | 0 | 0 | 0 | 0 | 1 | 1 | 1 | 0 | 0 | 0 | 0 | 0 | 0 | 1 | 1 | 0 | 0 | 0 | 0 | 0 | 0 |
| 20 | 010100 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 1 | 0 | 0 | 0 | 1 | 1 | 0 | 0 | 0 | 0 | 0 | 0 | 0 | 1 | 1 | 1 | 0 | 0 | 0 | 0 | 0 | 0 | 1 | 1 | 0 | 0 | 0 | 0 | 0 | 0 |
| 21 | 010101 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 1 | 0 | 0 | 1 | 1 | 0 | 0 | 0 | 0 | 0 | 0 | 0 | 1 | 1 | 1 | 0 | 0 | 0 | 0 | 0 | 0 | 1 | 1 | 0 | 0 | 0 | 0 | 0 | 0 |
| 22 | 010110 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 1 | 0 | 1 | 1 | 0 | 0 | 0 | 0 | 0 | 0 | 0 | 1 | 1 | 1 | 0 | 0 | 0 | 0 | 0 | 0 | 1 | 1 | 0 | 0 | 0 | 0 | 0 | 0 |
| 23 | 010111 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 0 | 1 | 1 | 1 | 0 | 0 | 0 | 0 | 0 | 0 | 0 | 1 | 1 | 1 | 0 | 0 | 0 | 0 | 0 | 0 | 1 | 1 | 0 | 0 | 0 | 0 | 0 | 0 |
| 24 | 011000 | 0 | 0 | 0 | 1 | 0 | 0 | 0 | 0 | 0 | 0 | 0 | 0 | 0 | 1 | 0 | 0 | 0 | 0 | 1 | 0 | 0 | 0 | 0 | 0 | 0 | 0 | 1 | 1 | 1 | 0 | 0 | 0 | 0 | 0 | 0 | 1 | 1 | 1 | 1 | 0 | 0 | 0 | 0 | 0 | 1 | 1 | 1 | 0 | 0 | 0 | 0 | 0 |
| 25 | 011001 | 0 | 0 | 0 | 1 | 0 | 0 | 0 | 0 | 0 | 0 | 0 | 0 | 0 | 1 | 0 | 0 | 0 | 0 | 0 | 1 | 0 | 0 | 0 | 0 | 0 | 0 | 1 | 1 | 1 | 0 | 0 | 0 | 0 | 0 | 0 | 1 | 1 | 1 | 1 | 0 | 0 | 0 | 0 | 0 | 1 | 1 | 1 | 0 | 0 | 0 | 0 | 0 |
| 26 | 011010 | 0 | 0 | 0 | 1 | 0 | 0 | 0 | 0 | 0 | 0 | 0 | 0 | 0 | 1 | 0 | 0 | 0 | 0 | 0 | 0 | 1 | 0 | 0 | 0 | 0 | 0 | 1 | 1 | 1 | 0 | 0 | 0 | 0 | 0 | 0 | 1 | 1 | 1 | 1 | 0 | 0 | 0 | 0 | 0 | 1 | 1 | 1 | 0 | 0 | 0 | 0 | 0 |
| 27 | 011011 | 0 | 0 | 0 | 1 | 0 | 0 | 0 | 0 | 0 | 0 | 0 | 0 | 0 | 1 | 0 | 0 | 0 | 0 | 0 | 0 | 0 | 1 | 0 | 0 | 0 | 0 | 1 | 1 | 1 | 0 | 0 | 0 | 0 | 0 | 0 | 1 | 1 | 1 | 1 | 0 | 0 | 0 | 0 | 0 | 1 | 1 | 1 | 0 | 0 | 0 | 0 | 0 |
| 28 | 011100 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 1 | 0 | 0 | 0 | 1 | 1 | 1 | 0 | 0 | 0 | 0 | 0 | 0 | 1 | 1 | 1 | 1 | 0 | 0 | 0 | 0 | 0 | 1 | 1 | 1 | 0 | 0 | 0 | 0 | 0 |
| 29 | 011101 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 1 | 0 | 0 | 1 | 1 | 1 | 0 | 0 | 0 | 0 | 0 | 0 | 1 | 1 | 1 | 1 | 0 | 0 | 0 | 0 | 0 | 1 | 1 | 1 | 0 | 0 | 0 | 0 | 0 |
| 30 | 011110 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 1 | 0 | 1 | 1 | 1 | 0 | 0 | 0 | 0 | 0 | 0 | 1 | 1 | 1 | 1 | 0 | 0 | 0 | 0 | 0 | 1 | 1 | 1 | 0 | 0 | 0 | 0 | 0 |
| 31 | 011111 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 0 | 1 | 1 | 1 | 1 | 0 | 0 | 0 | 0 | 0 | 0 | 1 | 1 | 1 | 1 | 0 | 0 | 0 | 0 | 0 | 1 | 1 | 1 | 0 | 0 | 0 | 0 | 0 |
| 32 | 100000 | 0 | 0 | 0 | 0 | 1 | 0 | 0 | 0 | 0 | 0 | 0 | 0 | 0 | 0 | 1 | 0 | 0 | 0 | 1 | 0 | 0 | 0 | 0 | 0 | 0 | 0 | 1 | 1 | 1 | 1 | 0 | 0 | 0 | 0 | 0 | 1 | 1 | 1 | 1 | 1 | 0 | 0 | 0 | 0 | 1 | 1 | 1 | 1 | 0 | 0 | 0 | 0 |
| 33 | 100001 | 0 | 0 | 0 | 0 | 1 | 0 | 0 | 0 | 0 | 0 | 0 | 0 | 0 | 0 | 1 | 0 | 0 | 0 | 0 | 1 | 0 | 0 | 0 | 0 | 0 | 0 | 1 | 1 | 1 | 1 | 0 | 0 | 0 | 0 | 0 | 1 | 1 | 1 | 1 | 1 | 0 | 0 | 0 | 0 | 1 | 1 | 1 | 1 | 0 | 0 | 0 | 0 |
| 34 | 100010 | 0 | 0 | 0 | 0 | 1 | 0 | 0 | 0 | 0 | 0 | 0 | 0 | 0 | 0 | 1 | 0 | 0 | 0 | 0 | 0 | 1 | 0 | 0 | 0 | 0 | 0 | 1 | 1 | 1 | 1 | 0 | 0 | 0 | 0 | 0 | 1 | 1 | 1 | 1 | 1 | 0 | 0 | 0 | 0 | 1 | 1 | 1 | 1 | 0 | 0 | 0 | 0 |
| 35 | 100011 | 0 | 0 | 0 | 0 | 1 | 0 | 0 | 0 | 0 | 0 | 0 | 0 | 0 | 0 | 1 | 0 | 0 | 0 | 0 | 0 | 0 | 1 | 0 | 0 | 0 | 0 | 1 | 1 | 1 | 1 | 0 | 0 | 0 | 0 | 0 | 1 | 1 | 1 | 1 | 1 | 0 | 0 | 0 | 0 | 1 | 1 | 1 | 1 | 0 | 0 | 0 | 0 |
| 36 | 100100 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 1 | 0 | 0 | 0 | 1 | 1 | 1 | 1 | 0 | 0 | 0 | 0 | 0 | 1 | 1 | 1 | 1 | 1 | 0 | 0 | 0 | 0 | 1 | 1 | 1 | 1 | 0 | 0 | 0 | 0 |
| 37 | 100101 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 1 | 0 | 0 | 1 | 1 | 1 | 1 | 0 | 0 | 0 | 0 | 0 | 1 | 1 | 1 | 1 | 1 | 0 | 0 | 0 | 0 | 1 | 1 | 1 | 1 | 0 | 0 | 0 | 0 |
| 38 | 100110 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 1 | 0 | 1 | 1 | 1 | 1 | 0 | 0 | 0 | 0 | 0 | 1 | 1 | 1 | 1 | 1 | 0 | 0 | 0 | 0 | 1 | 1 | 1 | 1 | 0 | 0 | 0 | 0 |
| 39 | 100111 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 0 | 1 | 1 | 1 | 1 | 1 | 0 | 0 | 0 | 0 | 0 | 1 | 1 | 1 | 1 | 1 | 0 | 0 | 0 | 0 | 1 | 1 | 1 | 1 | 0 | 0 | 0 | 0 |
| 40 | 101000 | 0 | 0 | 0 | 0 | 0 | 1 | 0 | 0 | 0 | 0 | 0 | 0 | 0 | 0 | 0 | 1 | 0 | 0 | 1 | 0 | 0 | 0 | 0 | 0 | 0 | 0 | 1 | 1 | 1 | 1 | 1 | 0 | 0 | 0 | 0 | 1 | 1 | 1 | 1 | 1 | 1 | 0 | 0 | 0 | 1 | 1 | 1 | 1 | 1 | 0 | 0 | 0 |
| 41 | 101001 | 0 | 0 | 0 | 0 | 0 | 1 | 0 | 0 | 0 | 0 | 0 | 0 | 0 | 0 | 0 | 1 | 0 | 0 | 0 | 1 | 0 | 0 | 0 | 0 | 0 | 0 | 1 | 1 | 1 | 1 | 1 | 0 | 0 | 0 | 0 | 1 | 1 | 1 | 1 | 1 | 1 | 0 | 0 | 0 | 1 | 1 | 1 | 1 | 1 | 0 | 0 | 0 |
| 42 | 101010 | 0 | 0 | 0 | 0 | 0 | 1 | 0 | 0 | 0 | 0 | 0 | 0 | 0 | 0 | 0 | 1 | 0 | 0 | 0 | 0 | 1 | 0 | 0 | 0 | 0 | 0 | 1 | 1 | 1 | 1 | 1 | 0 | 0 | 0 | 0 | 1 | 1 | 1 | 1 | 1 | 1 | 0 | 0 | 0 | 1 | 1 | 1 | 1 | 1 | 0 | 0 | 0 |
| 43 | 101011 | 0 | 0 | 0 | 0 | 0 | 1 | 0 | 0 | 0 | 0 | 0 | 0 | 0 | 0 | 0 | 1 | 0 | 0 | 0 | 0 | 0 | 1 | 0 | 0 | 0 | 0 | 1 | 1 | 1 | 1 | 1 | 0 | 0 | 0 | 0 | 1 | 1 | 1 | 1 | 1 | 1 | 0 | 0 | 0 | 1 | 1 | 1 | 1 | 1 | 0 | 0 | 0 |
| 44 | 101100 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 1 | 0 | 0 | 0 | 1 | 1 | 1 | 1 | 1 | 0 | 0 | 0 | 0 | 1 | 1 | 1 | 1 | 1 | 1 | 0 | 0 | 0 | 1 | 1 | 1 | 1 | 1 | 0 | 0 | 0 |
| 45 | 101101 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 1 | 0 | 0 | 1 | 1 | 1 | 1 | 1 | 0 | 0 | 0 | 0 | 1 | 1 | 1 | 1 | 1 | 1 | 0 | 0 | 0 | 1 | 1 | 1 | 1 | 1 | 0 | 0 | 0 |
| 46 | 101110 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 1 | 0 | 1 | 1 | 1 | 1 | 1 | 0 | 0 | 0 | 0 | 1 | 1 | 1 | 1 | 1 | 1 | 0 | 0 | 0 | 1 | 1 | 1 | 1 | 1 | 0 | 0 | 0 |
| 47 | 101111 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 0 | 1 | 1 | 1 | 1 | 1 | 1 | 0 | 0 | 0 | 0 | 1 | 1 | 1 | 1 | 1 | 1 | 0 | 0 | 0 | 1 | 1 | 1 | 1 | 1 | 0 | 0 | 0 |
| 48 | 110000 | 0 | 0 | 0 | 0 | 0 | 0 | 1 | 0 | 0 | 0 | 0 | 0 | 0 | 0 | 0 | 0 | 1 | 0 | 1 | 0 | 0 | 0 | 0 | 0 | 0 | 0 | 1 | 1 | 1 | 1 | 1 | 1 | 0 | 0 | 0 | 1 | 1 | 1 | 1 | 1 | 1 | 1 | 0 | 0 | 1 | 1 | 1 | 1 | 1 | 1 | 0 | 0 |
| 49 | 110001 | 0 | 0 | 0 | 0 | 0 | 0 | 1 | 0 | 0 | 0 | 0 | 0 | 0 | 0 | 0 | 0 | 1 | 0 | 0 | 1 | 0 | 0 | 0 | 0 | 0 | 0 | 1 | 1 | 1 | 1 | 1 | 1 | 0 | 0 | 0 | 1 | 1 | 1 | 1 | 1 | 1 | 1 | 0 | 0 | 1 | 1 | 1 | 1 | 1 | 1 | 0 | 0 |
| 50 | 110010 | 0 | 0 | 0 | 0 | 0 | 0 | 1 | 0 | 0 | 0 | 0 | 0 | 0 | 0 | 0 | 0 | 1 | 0 | 0 | 0 | 1 | 0 | 0 | 0 | 0 | 0 | 1 | 1 | 1 | 1 | 1 | 1 | 0 | 0 | 0 | 1 | 1 | 1 | 1 | 1 | 1 | 1 | 0 | 0 | 1 | 1 | 1 | 1 | 1 | 1 | 0 | 0 |
| 51 | 110011 | 0 | 0 | 0 | 0 | 0 | 0 | 1 | 0 | 0 | 0 | 0 | 0 | 0 | 0 | 0 | 0 | 1 | 0 | 0 | 0 | 0 | 1 | 0 | 0 | 0 | 0 | 1 | 1 | 1 | 1 | 1 | 1 | 0 | 0 | 0 | 1 | 1 | 1 | 1 | 1 | 1 | 1 | 0 | 0 | 1 | 1 | 1 | 1 | 1 | 1 | 0 | 0 |
| 52 | 110100 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 1 | 0 | 0 | 0 | 1 | 1 | 1 | 1 | 1 | 1 | 0 | 0 | 0 | 1 | 1 | 1 | 1 | 1 | 1 | 1 | 0 | 0 | 1 | 1 | 1 | 1 | 1 | 1 | 0 | 0 |
| 53 | 110101 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 1 | 0 | 0 | 1 | 1 | 1 | 1 | 1 | 1 | 0 | 0 | 0 | 1 | 1 | 1 | 1 | 1 | 1 | 1 | 0 | 0 | 1 | 1 | 1 | 1 | 1 | 1 | 0 | 0 |
| 54 | 110110 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 1 | 0 | 1 | 1 | 1 | 1 | 1 | 1 | 0 | 0 | 0 | 1 | 1 | 1 | 1 | 1 | 1 | 1 | 0 | 0 | 1 | 1 | 1 | 1 | 1 | 1 | 0 | 0 |
| 55 | 110111 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 0 | 1 | 1 | 1 | 1 | 1 | 1 | 1 | 0 | 0 | 0 | 1 | 1 | 1 | 1 | 1 | 1 | 1 | 0 | 0 | 1 | 1 | 1 | 1 | 1 | 1 | 0 | 0 |
| 56 | 111000 | 0 | 0 | 0 | 0 | 0 | 0 | 0 | 1 | 0 | 0 | 0 | 0 | 0 | 0 | 0 | 0 | 0 | 1 | 1 | 0 | 0 | 0 | 0 | 0 | 0 | 0 | 1 | 1 | 1 | 1 | 1 | 1 | 1 | 0 | 0 | 1 | 1 | 1 | 1 | 1 | 1 | 1 | 1 | 0 | 1 | 1 | 1 | 1 | 1 | 1 | 1 | 0 |
| 57 | 111001 | 0 | 0 | 0 | 0 | 0 | 0 | 0 | 1 | 0 | 0 | 0 | 0 | 0 | 0 | 0 | 0 | 0 | 1 | 0 | 1 | 0 | 0 | 0 | 0 | 0 | 0 | 1 | 1 | 1 | 1 | 1 | 1 | 1 | 0 | 0 | 1 | 1 | 1 | 1 | 1 | 1 | 1 | 1 | 0 | 1 | 1 | 1 | 1 | 1 | 1 | 1 | 0 |
| 58 | 111010 | 0 | 0 | 0 | 0 | 0 | 0 | 0 | 1 | 0 | 0 | 0 | 0 | 0 | 0 | 0 | 0 | 0 | 1 | 0 | 0 | 1 | 0 | 0 | 0 | 0 | 0 | 1 | 1 | 1 | 1 | 1 | 1 | 1 | 0 | 0 | 1 | 1 | 1 | 1 | 1 | 1 | 1 | 1 | 0 | 1 | 1 | 1 | 1 | 1 | 1 | 1 | 0 |
| 59 | 111011 | 0 | 0 | 0 | 0 | 0 | 0 | 0 | 1 | 0 | 0 | 0 | 0 | 0 | 0 | 0 | 0 | 0 | 1 | 0 | 0 | 0 | 1 | 0 | 0 | 0 | 0 | 1 | 1 | 1 | 1 | 1 | 1 | 1 | 0 | 0 | 1 | 1 | 1 | 1 | 1 | 1 | 1 | 1 | 0 | 1 | 1 | 1 | 1 | 1 | 1 | 1 | 0 |
| 60 | 111100 | 0 | 0 | 0 | 0 | 0 | 0 | 0 | 1 | 0 | 0 | 0 | 0 | 0 | 0 | 0 | 0 | 0 | 1 | 0 | 0 | 0 | 0 | 1 | 0 | 0 | 0 | 1 | 1 | 1 | 1 | 1 | 1 | 1 | 0 | 0 | 1 | 1 | 1 | 1 | 1 | 1 | 1 | 1 | 0 | 1 | 1 | 1 | 1 | 1 | 1 | 1 | 0 |
| 61 | 111101 | 0 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 1 | 0 | 0 | 1 | 1 | 1 | 1 | 1 | 1 | 1 | 0 | 0 | 1 | 1 | 1 | 1 | 1 | 1 | 1 | 1 | 0 | 1 | 1 | 1 | 1 | 1 | 1 | 1 | 0 |
| 62 | 111110 | 0 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 1 | 0 | 1 | 1 | 1 | 1 | 1 | 1 | 1 | 0 | 0 | 1 | 1 | 1 | 1 | 1 | 1 | 1 | 1 | 0 | 1 | 1 | 1 | 1 | 1 | 1 | 1 | 0 |
| 63 | 111111 | 0 | 0 | 0 | 0 | 0 | 0 | 0 | 1 | 0 | 0 | 0 | 0 | 0 | 0 | 0 | 0 | 0 | 1 | 0 | 0 | 0 | 0 | 0 | 0 | 0 | 1 | 1 | 1 | 1 | 1 | 1 | 1 | 1 | 0 | 0 | 1 | 1 | 1 | 1 | 1 | 1 | 1 | 1 | 0 | 1 | 1 | 1 | 1 | 1 | 1 | 1 | 0 |

Fig 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2001038351 A1
- US 5767733 A
- US 5495245 A